# EUROPEAN PATENT SPECIFICATION

(11) **EP 1 842 634 B1**
(45) Date of publication and mention of the grant of the patent: **23.11.2011**
(21) Application number: 07251220.5
(22) Date of filing: 22.03.2007
(51) Int. Cl.: B26F 1/02

(54) **Method of manufacturing industrial component having through holes with high aspect ratio**
Verfahren zur Herstellung industrieller Komponenten mit Durchgangsbohrungen mit hohem Aspektverhältnis
Procédé de fabrication d'un composant industriel comportant des trous avec un rapport de forme élevé

(30) Priority: 28.03.2006 JP 2006087463
(43) Date of publication of application: 10.10.2007
(73) Proprietor: NGK Insulators, Ltd., Nagoya-City, Aichi Pref. 467-8530 (JP)
(72) Inventor: Kitamura, Kazumasa, c/o NGK Insulators, Ltd., Nagoya City, Aichi-ken, 467-8530 (JP); Yamaguchi, Yoshinori, c/o NGK Insulators, Ltd., Nagoya City, Aichi-ken, 467-8530 (JP)
(74) Representative: Naylor, Matthew John

(56) References cited:
- EP-A2- 1 175 978
- US-A- 5 577 427

## Description

### BACKGROUND OF THE INVENTION

### 1. Field of the Invention

The present invention relates to a method of manufacturing an industrial component highly densely having through holes with a high aspect ratio, and more specifically to a method of manufacturing an industrial component for highly accurately forming a large number of through holes with an extremely narrow bar width and a long bar length.

### 2. Description of the Related Art

A common request for all of industrially manufactured products is to be more inexpensive, lighter, and smaller. Particularly in an industrial product mounted with a large number of electronic circuits, to be small is an added value. Therefore, the mounting technology for supporting such size reduction has remarkably developed. In the development, it is required in a wiring board mounted with an electronic component that small through holes are manufactured with precision and accuracy for forming a circuit of higher density while ensuring high reliability for the cooling effect. Further, in other products such as an ink discharge portion of an inkjet printer, smaller through holes than the through holes of the wiring board need to be formed with high accuracy, for example. Thus, the technique of highly accurately forming small through holes in an industrial component is essential.

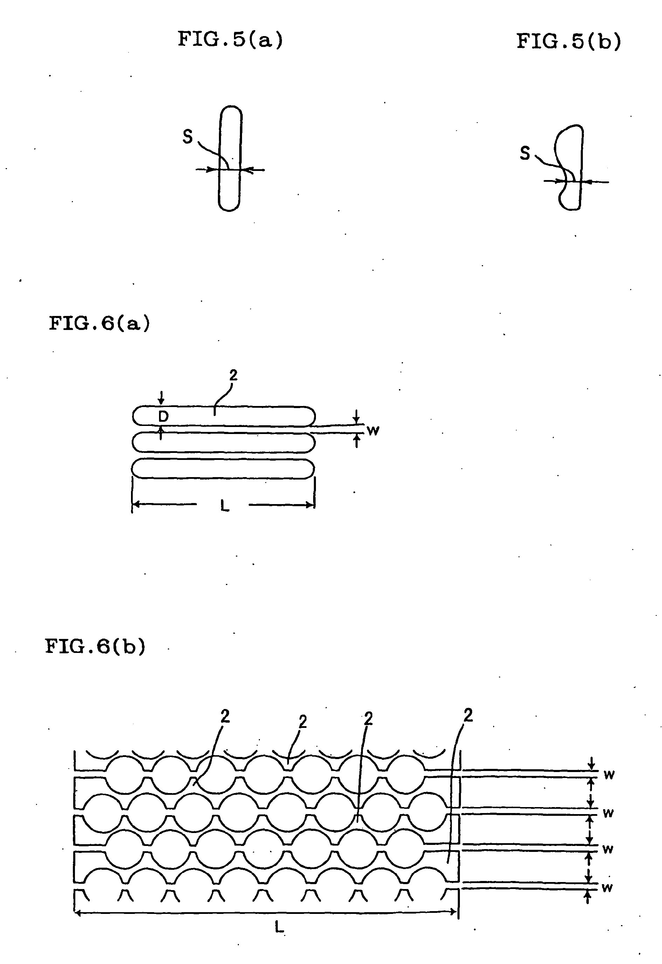

The tendency toward high density has been increasingly developed recently, and thus a larger number of small through holes need to be formed within a fixed area of a material board. Consequently, the through holes become smaller and deeper, i.e., smaller in diameter and longer in axial length thereof. That is, the through holes have a higher aspect ratio, and the holes need to be formed with high accuracy. When a through hole is of a cylindrical shape, the aspect ratio generally refers to the ratio between the diameter and the axial length of the through hole. When the through hole is not of a cylindrical shape, the aspect ratio refers to the ratio between the axial length and the shortest distance from an edge on an open plane of the through hole to the opposite edge. The shortest distance from the edge to the opposite edge refers herein to a shortest distance S shown in Figs. 5(a) and 5(b). That is, a through hole having a high aspect ratio refers to an elongated hole, the axial length of which is long as compared with the diameter or the shortest distance of the hole.

As one of such conventional methods of forming a large number of small through holes in a plate material, there is a hole processing using a punching mold. The processing is a method of punching a plate material of a predetermined thickness, which form an industrial component, at a time by using a punch and a die. The method is originally intended to punch a thick plate material, and thus a clearance, i.e., a gap between the punch and the die needs to be increased. Therefore, the accuracy is deteriorated. Further, in a punching operation, larger shearing force works on the thick plate material than when a thin plate material is punched. The die needs to have a large number of holes particularly when the density of the through holes is high. In such a case, the strength of the die cannot endure the large shearing force, and the die is deformed or even damaged due to insufficient rigidity thereof.

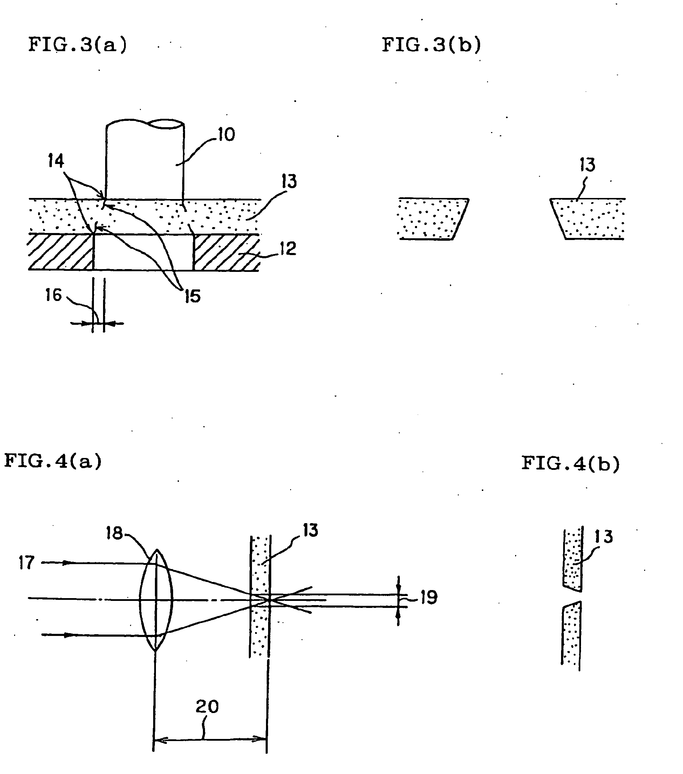

Figs. 3(a) and 3(b) are diagrams illustrating an opening of a through hole formed by a punching mold. As illustrated in Fig. 3(a), a plate material 13 placed on a die 12 is punched by a punch 10, with a clearance 16, i.e., a gap between the punch 10 and the die 12, formed. As a result, cracks 15 generally occur at respective edges 14 of the punch 10 and the die 12. The cracks 15 occur within the clearance 16, and the accuracy of the through hole varies within the clearance 16. Accordingly, generally in a through hole opening method using a punching mold, the cross-sectional shape of a through hole formed in a plate material after the punching is taper-shaped, flared in the punching direction, as illustrated in Fig. 3(b).

According to "Kihon Kikai Kosaku I (Basic Machine Engineering I)" published by Nikkan Kogyo Shimbun, Ltd., the clearance 16 required for the punching mold has 4 to 12% of the plate thickness of a thin plate and 18 to 26% of the plate thickness of a thick plate. That is, the clearance 16 is increased as the plate thickness is increased. In other words, as described above, the accuracy of the through hole is decreased as the thickness of the plate material is increased. Thus, the diameter of the through hole varies on the exit side thereof in the punching direction. Therefore, the method is not suitable as the method of highly densely forming small through holes with a high aspect ratio.

As an improved method of the above hole processing using the punching mold, there is a method intended to punch a thin plate material, according to which punched plate materials are moved and stacked to obtain an industrial component of a predetermined thickness. In this method, the plate thickness of the material punched at a time is thin. Thus, the accuracy of the holes formed in each sheet of the plate materials at each punching operation is good. Further, the shearing force of the punch and the die can be suppressed. Thus, the holes can be formed in high density. However, the method requires a jig for moving the plate materials and a space for stacking the plate materials. Further, the number of steps is increased, and the production efficiency is decreased. As a result, the cost is increased. Furthermore, guide pins are required to accurately stack the plate materials, and extra holes other than the necessary holes are formed in the industrial component. In addition, if the plate materials are formed of such a flexible material that is deformed after the punching, positional differences are caused among the holes while the plate materials are moved and stacked. Thus, when the plate materials are stacked to form an industrial component of a predetermined thickness, the accuracy of the through holes is deteriorated. Therefore, the method is also unsuitable as the method of highly densely forming small through holes with a high aspect ratio.

As a conventional method, there is a hole processing using laser instead of the punching mold. The processing uses laser beam, and is a method of processing a target material by condensing beam light through a lens and applying the condensed beam light to the material. In the laser processing, a through hole is formed into a tapered shape, narrowed in the traveling direction of the beam light due to the light condensing method, which is the basic principle of the processing. The processing, therefore, faces a fundamental issue of deterioration of the accuracy is deteriorated at a high aspect ratio.

Figs. 4(a) and 4(b) are diagrams illustrating an opening of a through hole formed by the laser processing. As illustrated in Fig. 4(a), in a laser processing machine, parallel beam light 17 passes through a condenser lens 18 and is condensed and processed at a position apart from the condenser lens 18 by a focal distance 20. As the beam light 17 is distanced from the focal point, a laser light width 19 is increased, and the diameter of the processed through hole is increased. Therefore, as the plate thickness of the plate material is increased, the diameter of the through hole formed on the entrance side of the plate material in the traveling direction of the beam light is increased while the hole processing is being performed on the exit side of the plate material in the traveling direction of the beam light. As a result, the through hole of a narrowed tapered shape as illustrated in Fig. 4(b) is formed.

Further, since the laser processing uses heat energy, the processed plate material is deformed due to the heat, and an affected layer is formed. As a result, there arises another issue of variation in diameter of through holes. In this case, too, a thicker plate material requires a larger amount of laser beam, i.e., heat energy. Thus, the thicker the plate thickness of the plate material is, the lower the accuracy of the through holes becomes. Therefore, the laser processing is also unsuitable as the method of highly densely forming small through holes with a high aspect ratio.

As described above, the mounting technique mainly used for electronic components in the industrial field has been developed toward high density. Thus, in an industrial component required to be highly densely formed with miniaturized through holes, a method has been sought for which forms through holes with a higher aspect ratio with higher accuracy and safety without causing damage, even if the method uses a flexible material having such a size or shape that causes deformation in the material due to the handling after the hole processing. In light of this, the present applicant has recently proposed a few methods (see Japanese Patent Application Laid-open Nos. 2002-160194 and 2002-160195, for example).

EP-A-1175978 describes a fabrication method of an industrial part having high-aspect-ratio through-hole sections using a punch and a die, including: a first step of drilling a first hole section in a first sheet of sheet material with said punch; a second step of lifting said first sheet in tight contact with a stripper under a condition that said punch is not pulled out from the first hole section; a third step of lifting said punch so that a tip section of said punch is slightly drawn in from a bottom section of said lifted first sheet of sheet material; a fourth step of drilling a second hole section in a second sheet of sheet material with said punch; a fifth step of lifting said second sheet in tight contact with said first sheet under a condition that said punch is not pulled out from the second hole section; and a sixth step of lifting said punch so that a tip of said punch is slightly drawn in from the bottom section of said lifted second sheet of sheet material.

According to the methods described in the above publications, however, if the punched pattern of the plate material to be punched includes a portion having a narrow bar width, and if the aspect ratio of the through holes is high, the bar portion is bent under the self weight thereof. As a result, positional differences are caused among the holes, and the through holes cannot be formed with high accuracy.

### SUMMARY OF THE INVENTION

The present invention has been made in view of the above-described circumstances, and it is an object of the present invention to provide a method of manufacturing an industrial component capable of overcoming the above-described circumstances of the conventional techniques and also capable of highly accurately forming through holes in a target object even with a narrow bar width and a long bar length.

The present invention provides a method of manufacturing an industrial component having through holes with a high aspect ratio by using a punch and a die. The method comprises the features of claim 1. In the method, the punch has leading ends formed into punching cutters and serving as stacking axes of plural sheets of punch materials. The plural sheets of punch materials are punched by the punch, and thereafter are kept held by a side surface of the punch. When a given punch material is held by the side surface of the punch, a next punch material is punched and stacked with the leading ends of the punch projecting farther than the lowest surface of the given punch material.

The method according to the present invention is suitable for forming through holes with a narrow through hole interval (i.e., bar width) W and a long bar length L in a punch material of a punched shape having a ratio (L/W) of greater than 17 between the through hole interval (i.e., bar width) W and the bar length L. Further, the method according to the present invention can be preferably applied to highly accurately form minute through holes with an extremely narrow through hole interval (i.e., bar width) W and a long bar length L in a punch material having specific sizes of a through hole interval (i.e., bar width) W of equal to or less than 0.07 mm, a bar length L of equal to or greater than 0.6 mm, and a thickness of equal to or less than 0.11 mm.

The manufacturing method according to the present invention exerts a significant effect of capable of obtaining an industrial component highly accurately formed with through holes, even when forming the through holes in a punch material (i.e., plate material) with a narrow bar width and a long bar length.

### BRIEF DESCRIPTION OF THE DRAWINGS

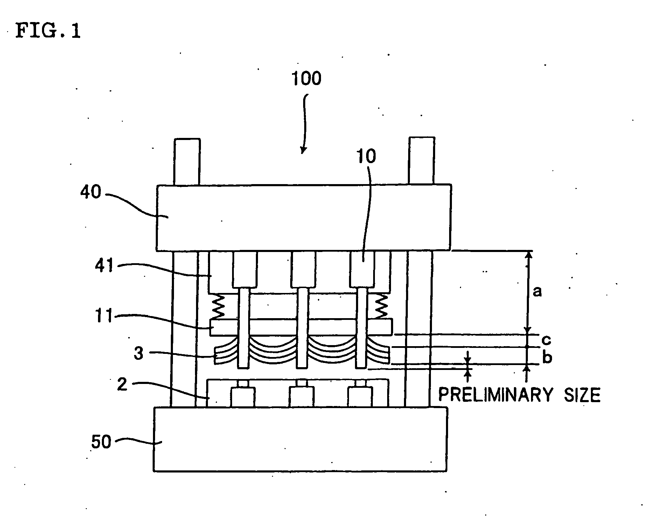

Fig. 1 is an overview diagram illustrating an example of a manufacturing method according to the present invention;

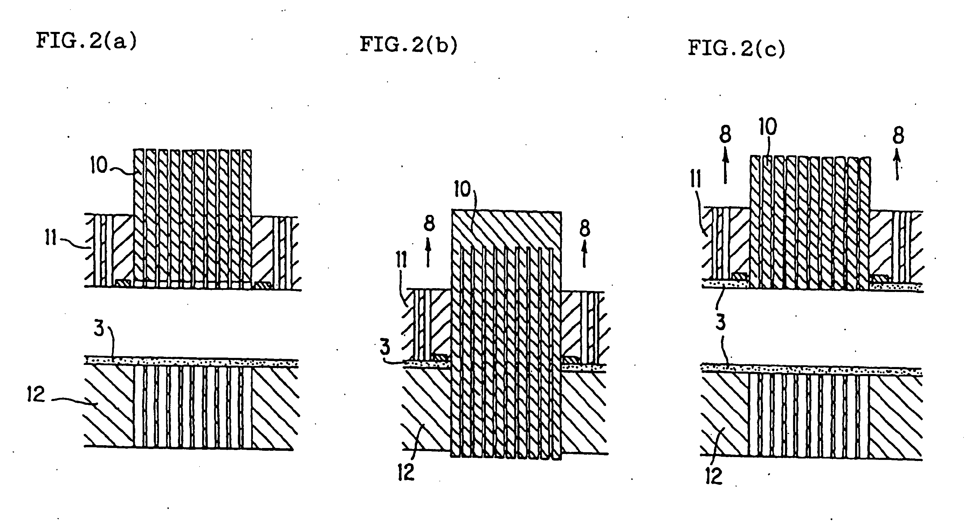

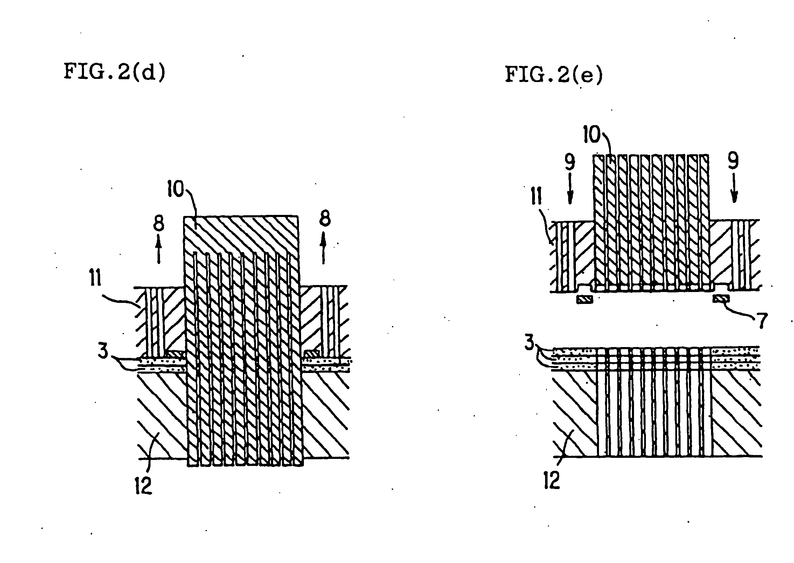

Figs. 2(a) to 2(e) are step explanatory diagrams illustrating an example of the method according to the present invention of manufacturing an industrial component having through holes with a high aspect ratio by using a punch and a die, with Fig. 2(a) illustrating a first sheet preparation step of placing the first sheet of thin plate materials on the die, Fig. 2(b) illustrating a first sheet punching step of punching the first sheet with the punch, Fig. 2(c) illustrating a second sheet preparation step, Fig. 2(d) illustrating a second sheet punching step, and Fig. 2(e) illustrating a sheet punching completion step of separating stacked plate materials with a stripper after completion of punching and stacking of all sheets;
Figs. 3(a) and 3(b) are diagrams illustrating an opening of a through hole formed by a punching mold according to a conventional method, with Fig. 3(a) being a pattern diagram illustrating a situation in which cracks occur, and Fig. 3(b) being an explanatory diagram illustrating a cross-sectional shape of the through hole formed in a plate material after punching;
Figs. 4(a) and 4(b) are diagrams illustrating an opening of a through hole formed by laser processing according to a conventional method, with Fig. 4(a) being a pattern diagram illustrating a processing state using laser beam, and Fig. 4(b) being an explanatory diagram illustrating a cross-sectional shape of the through hole formed after the laser processing;
Figs. 5(a) and 5(b) are diagrams illustrating an industrial component having through holes with a high aspect ratio according to the present invention, with Fig. 5(a) being an explanatory diagram illustrating an example of the shortest distance of a through hole, and Fig. 5(b) being an explanatory diagram illustrating another example of the shortest distance of the through hole;
Figs. 6(a) and 6(b) are diagrams illustrating examples of cross-sectional shapes of the through holes with a high aspect ratio according to the present invention, with Fig. 6(a) illustrating an example of through holes of a typical elongated punched shape, and Fig. 6(b) illustrating an example in which a punched shape (i.e., bar shape) is a plurality of circles connected to one another;

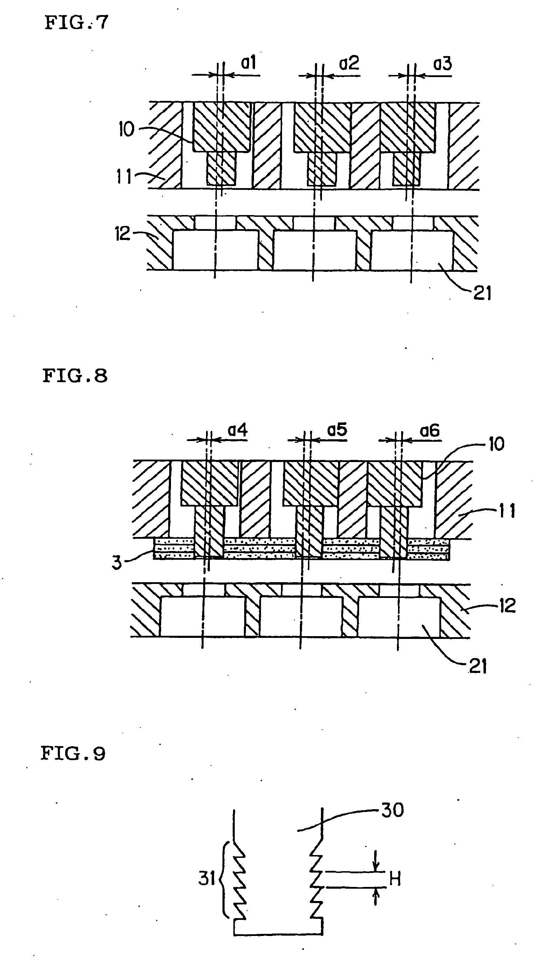

Fig. 7 is an explanatory diagram illustrating an example of a conventional punching method using a punch and a die;
Fig. 8 is an explanatory diagram illustrating an example of the method according to the present invention of manufacturing an industrial component having through holes with a high aspect ratio by using a punch and a die; and
Fig. 9 is a side view illustrating an embodiment of the punch used in the method according to the present invention of manufacturing an industrial component having through holes with a high aspect ratio.

### DESCRIPTION OF THE PREFERRED EMBODIMENTS

Specific description will now be made on embodiments of a method according to the present invention of manufacturing an industrial component having through holes with a high aspect ratio. The present invention, however, is not interpreted as limited to the embodiments, and thus can be added with various changes, alterations, and modifications on the basis of the knowledge of a person skilled in the art within a range not departing from the scope of the present invention.

In the present invention, a punch itself is used as stacking axes, such as guide pins used in a conventional method. In stacking punch materials, which are plate materials each formed of a thin flexible material, within a manufacturing apparatus including a punch and a die, a punch material is punched and stacked with leading ends of the punch projecting farther than the lowest surface of a preceding punch material.

Fig. 1 is an overview diagram illustrating an example of the manufacturing method according to the present invention. In Fig. 1, the reference numeral 100 denotes a punching machine used in the present invention, and a punch 10 is fixed downward to a punch holder 41 which is located under an upper mold 40. The punch 10 has leading ends formed into punching cutters and serving as stacking axes of plural sheets of plate materials (i.e., punch materials) 3, as described later. The reference numeral 50 denotes a lower mold, on which a die 12 is placed.

Fig. 1 illustrates a state in which the punching machine 100 is positioned at the top dead center thereof (i.e., a state prior to the punching). In the state of Fig. 1, three sheets of the punch materials 3 have been punched and are kept held by and stacked on a side surface of the punch 10, with the punch 10 serving as the stacking axes. A characteristic of the present invention lies in that, in the above process, the leading ends of the punch 10 project farther downward than the lowest surface of the three sheets of the punch materials 3, i.e., the lowest surface of the punch materials 3 does not project farther downward than the leading ends of the punch 10, when a next punch material is punched and stacked. In stacking punch materials, which are plate materials each formed of a thin flexible material, if the through holes are formed with a narrow bar width and a long bar length, bar portions are significantly bent due to the self weight thereof. In this state, if the lowest surface of the punch materials 3 projects farther downward than the leading ends of the punch 10 even by a slight distance, the punch materials 3 are displaced in position in the lateral direction, and positional differences are caused among the holes during the stacking step. As a result, the through holes cannot be formed with high accuracy.
According to the present invention, the punch materials are sequentially punched and stacked, as described above. Therefore, even when punching to form through holes in a punch material with a narrow bar width and a long bar length, the through holes can be formed with high accuracy.

Fig. 7 illustrates an example of a conventional punching method using a punch and a die. As long as the punch 10 moves in holes of a stripper 11, a certain clearance needs to be formed between the punch 10 and the holes of the stripper 11. As a result, the positional differences are inevitably caused between the central axes of the punch 10 and the central axes of the holes of the stripper 11.
As illustrated in Fig. 7, conventionally, the direction and the size of positional differences a1, a2, and a3 caused between the central axes of the punch 10 and the central axes of the holes of the stripper 11 are changed in every punching operation, and thus the position of the holes formed in the plate materials is different from sheet to sheet. Therefore, when the thus punched plate materials are stacked to form through holes, the obtained holes do not have high accuracy.

According to the prevent invention, the punch materials are stacked, with the punch serving as the axes. Thus, the punch materials function to hold and fix the punch. Therefore, the direction and the size of the positional differences between the central axes of the punch and the central axes of the holes of the stripper are unchanged in each punching operation. That is, force within a range of elastic deformation works on the holes punched in the raised punch materials, in a direction of constricting the punch from the outer circumferences thereof (i.e., in the radial direction). Thus, the punch can be held. Accordingly, the holes of higher accuracy can be formed in the punch materials.

Fig. 8 is an explanatory diagram illustrating an example of the method according to the prevent invention of manufacturing an industrial component having through holes with a high aspect ratio, and illustrates a state in which the stripper 11 is raised after three sheets of the punch materials 3 have been punched. As in the present example, in a case in which three sheets of the punch materials 3 are formed with through holes, there are positional differences a4, a5, and a6 of different directions and sizes between the central axes of the punch 10 and the central axes of the holes of the stripper 11. However, the punch materials 3 are stacked with the punch 10 serving as the axes, and thus the respective positional differences a4, a5, and a6 are unchanged in the corresponding holes of the three sheets of the punch materials 3. Therefore, the through holes formed by the stacked three sheets of the punch materials 3 have higher accuracy. Further, the punch materials 3 support the punch 10 around leading end portions of the punch 10, as illustrated in Fig. 8. Thus, the punch materials 3 also have the function of preventing the leading end portions of the punch 10 from buckling.

The following examples illustrated in Figs. 6(a) and 6(b) are preferable punched shapes of the punch material, to which the present invention is applied, and which are required in a wiring board of an electronic circuit or an ink discharge portion of a printer. Fig. 6(a) illustrates an example in which the punched shape has typical elongated through holes, while Fig. 6(b) illustrates an example in which the punched shape (i.e., the bar shape) is a plurality of circles connected to one another.
As illustrated in Figs. 6(a) and 6(b), in the industrial component formed by punch materials, to which the present invention is applied, the present invention can be applied to such a punched shape that has a ratio (L/W) of greater than 17 between the interval between adjacent through holes 2 (i.e., the bar width) W and the bar length L. As for specific sizes, the present invention can be preferably applied to form minute through holes of an elongated oval shape with an extremely narrow bar width and a long bar length, i.e., a through hole interval (i.e., a bar width) W of equal to or less than 0.07 mm and a bar length L of equal to or greater than 0.6 mm, in a punch material having a thickness of equal to or less than 0.11 mm. It is required in the industrial component that a large number of such fine bars having a width of equal to or less than 0.1 mm are formed with high shape accuracy with intervals of equal to or less than 0.1 mm. Such requirement can be satisfied by the method according to the present invention of manufacturing an industrial component having through holes with a high aspect ratio.

The present invention can be preferably applied to a punch material of a punched shape having a ratio (L/W) of greater than 17, 34, or 50 between the interval between adjacent through holes 2 (i.e., the bar width) W and the bar length L.
As for specific sizes, the present invention can be applied to a punch material having a thickness of preferably equal to or less than 0.11 mm, more preferably equal to or less than 0.05 mm, a through hole interval (i.e., a bar width) W of preferably equal to or less than 0.07 mm, more preferably equal to or less than 0.04 mm, and a bar length L of preferably equal to or greater than 0.6 mm, more preferably equal to or greater than 1.2 mm.
A through hole of high shape accuracy herein refers to a through hole in which a through hole diameter D is approximately constant within the entire segment of the bar length L, i.e., a hole pierced straight through the thickness of a punch material.

The flexible material used in the industrial component manufacturing method according to the present invention, which has such a size or shape that causes deformation in the material due to the handling after the punching, is a flexible material having a Young's modulus of less than 3000 kgf/mm², for example. The flexible material includes polyethylene (a Young's modulus of 310 kgf/mm²), polyimide (a Young's modulus of 430 kgf/mm²), a reinforced plastic (a Young's modulus of 2500 kgf/mm²), a green sheet (a Young's modulus of 4 kgf/mm²), and so forth. Further, those materials having a Young's modulus of equal to or greater than 3000 kgf/mm² are all usable in the present invention, if the materials have such a size or shape that causes deformation in the materials due to the handling after the punching.

Description will now be made on an example of the method according to the present invention of manufacturing an industrial component having through holes with a high aspect ratio.
With reference to Figs. 2(a) to 2(e), overview steps of the manufacturing method will be first described.
A punching machine includes, as main devices thereof, a punch 10, a die 12, and a stripper 11. In the punching machine, thin plate materials (i.e., punch materials) 3 are individually placed on the die 12 and punched by the punch 10. Although the quality, the size, and the thickness of the thin punch material 3 are not particularly limited, a green sheet having a thickness of 0.05 mm can be used, for example.

Fig. 2(a) illustrates a state in which the first sheet of the thin plate materials 3 is placed on the die 12 in preparation for the punching. Then, as illustrated in Fig. 2(b), the first sheet of the plate materials 3 is punched by the punch 10. Thereafter, the punching machine moves to the preparation for the punching of the second sheet, as illustrated in Fig. 2(c). In this step, unlike the conventional method in which the punched first sheet of the plate materials 3 is moved to another place and stacked there, the punched first sheet is moved upward while kept pierced in the punch 10 and in close contact with the stripper 11. The plate material 3 may be made in close contact with the stripper 11 by vacuum suction 8 through air inlets piercing through the stripper 11, as illustrated in Fig. 2(c), or by applying an adhesive agent to a surface of the first sheet of the thin plate materials 3, for example, to thereby cause the first sheet to adhere to the stripper 11.

Further, to move to the preparation for the punching of the second sheet, the punch 10 and the stripper 11 are raised from the die 12, as illustrated in Fig. 2(c). It is important at this stage to stop the punch 10 when the punch 10 projects slightly farther than the lowest part of the first sheet of the plate materials 3, which is raised together with the punch 10. As described above, in forming through holes with an extremely narrow through hole interval (i.e., bar width) and a long bar length, if a plate material 3 is punched and stacked with the punch 10 retreated from the lowest part of a preceding plate material 3, the bar portions of the preceding plate material 3 sag due to the self weight thereof and are caught by lower portions of the punch 10 in many cases. The above technique is for preventing such a situation from occurring.

As described above, the punch 10 itself is used as the stacking axes of the thin plate materials such as the guide pins used in the conventional method, and the holes punched by the punch 10 itself are prevented from being deformed. Thereby, while a device for stacking the thin plate materials is preserved, a jig for moving the plate materials 3 and a space for stacking the plate materials 3 become unnecessary, and thus the increase in number of manufacturing steps is more suppressed. It is therefore possible to manufacture at lower cost an industrial component 1 which highly densely have through holes formed with a high aspect ratio and with the same high accuracy as the accuracy of the holes formed in a single sheet of the thin plate material 3.

Fig. 2(d) illustrates a punching step of the second sheet of the plate materials 3. Subsequent to this step, the preparation for the next punching as illustrated in Fig. 2(c) is performed. These steps are repeated to sequentially stack plural sheets of the plate materials 3 in the punching machine.
As illustrated in Fig. 2(e), all sheets of the plate materials 3 are punched and stacked, and thereafter the stacked plate materials 3 are separated from the stripper 11. Thereby, the punching operation is completed.

The stacked plate materials 3 can be removed from the stripper 11 by, for example, stopping the vacuum suction used to raise the plate materials 3 for breaking the vacuum, and then mechanically removing the plate materials 3 with a separation jig 7. In this process, instead of placing on the die 12 the plate materials 3 removed from the punch 10 and the stripper 11 and then taking out the plate materials 3, a work receiving jig may be inserted on the die 12 so that the stacked plate materials 3 are moved onto the work receiving jig to be moved to the next step, for example. This configuration is preferable in that the working efficiency is improved. The configuration is also preferable when the plate materials 3 are flexible, since the deformation of the materials is suppressed.

When the plate materials 3 are stacked to form the industrial component 1, the respective plate materials 3 need to be adhered to one another. The adhesion may be performed by previously applying an adhesive agent to the surfaces of the respective plate materials 3, or by placing an adhesive sheet between each adjacent ones of plate materials 3. If the adhesive sheet is used, the number of steps of the punching operation is increased. Thus, it is preferable to use the plate materials 3 having the surfaces previously provided with adhesiveness. Alternatively, the plate materials may be previously formed with holes usable for the vacuum suction so that the respective plate materials are stacked in close contact with one another by the vacuum suction.

The disposition position of the vacuum suction holes is unlimited. However, since the plate materials are raised by suction force, it is preferable to equally form the vacuum suction holes on the four sides of each sheet of the plate materials except for the last sheet of the plate materials, which does not need the vacuum suction holes.

Usually, the entire vacuum suction is performed by a single vacuum apparatus. In such a case, the vacuum suction holes remain open, except when the last sheet of the plate materials is vacuum-suctioned. Under such a condition, the vacuum state cannot be obtained. To solve this situation, the vacuum state can be ensured by individually determining the location of the vacuum suction for the respective sheets, separating wiring lines, and providing a control valve to the lines, for example. The suction force required for raising the plate materials can be also obtained by forming a narrowed portion in each of the vacuum suction holes.

As still another method of stacking the plate materials, it is also preferable to make the surface of the punch roughly finished for increasing frictional force generated between the punch and the plate materials to thereby have the plate materials held by the punch with the frictional force. With the plate materials held by the punch, the sequentially punched plate materials are stacked in close contact with the stripper. Generally, due to the internal stress generated in the punching process, the punched holes are elastically deformed in the direction of constricting the punch, i.e., in a manner of decreasing the diameter of the holes. The degree of deformation is large particularly in a material of high elasticity. Therefore, the plate materials can be held by the punch simply by roughly finishing the surface of the punch.

When a material of high elasticity is used to form the plate materials, it is also preferable to use a punch 30 having a surface formed with a bamboo-shaped step portion 31, as illustrated in Fig. 9, so that the plate materials are more reliably held by the punch. With this configuration, each one of the plate materials steps over the step portion 31 without being plastically deformed at the moment when the plate material is punched by the punch 30, and the plate materials are sequentially stacked. If a step height H of the punch 30 is set to be equal to the thickness of each of the plate materials, the plate materials can be stacked in close contact with one another. Further, the plate materials are caught by the step portion 31 due to the elastic deformation, and thus are prevented from slipping out of the punch 30.

### Embodiments:

The present invention will now be described by referring to embodiments thereof to confirm the effects of the invention.
Embodiment 1: A punching machine including a punch and a die of the sizes as shown in Table 1 was used, and a piezoelectric sheet having a Young's modulus of 11.4 kgf/mm² and an elastic strain of 0.105 as shown in Table 1 was used as the punch material (i.e., the plate material). Further, as illustrated in Fig. 1, a punch material was punched and stacked, with the leading ends of the punch projecting farther than the lowest surface of a preceding punch material. Thereby, through holes were formed with a through hole interval (i.e., a bar width) of 1.913 mm, a bar length of 96.82 mm, and a through hole width (i.e., a cavity width) of 1.148 mm.
In this process, the stacked materials were formed by stacking 200 piezoelectric sheets, with each of the sheets set to have a thickness of 0.11 mm, and the punch serving as the stacking axes. It was found from the quality measurement of the through holes of the obtained stacked materials that the shape accuracy was good and that a residue removal operation was easily performed.

Embodiments 2 to 15: Punching machines respectively including punches and dies of the sizes as shown in Table 1 were used, and punch materials (i.e., plate materials) as shown in Table 1 were used. Further, in a similar manner to Embodiment 1, through holes of the shapes and sizes as shown in Table 1 were formed. The obtained results are shown in Table 1.

Comparative Example 1: Through holes of the shapes and sizes as shown in Table 1 were formed in a similar manner to Embodiment 8 except that a punch material is punched with the punch slightly retreated from the lowest surface of a preceding punch material. The obtained results are shown in Table 1.

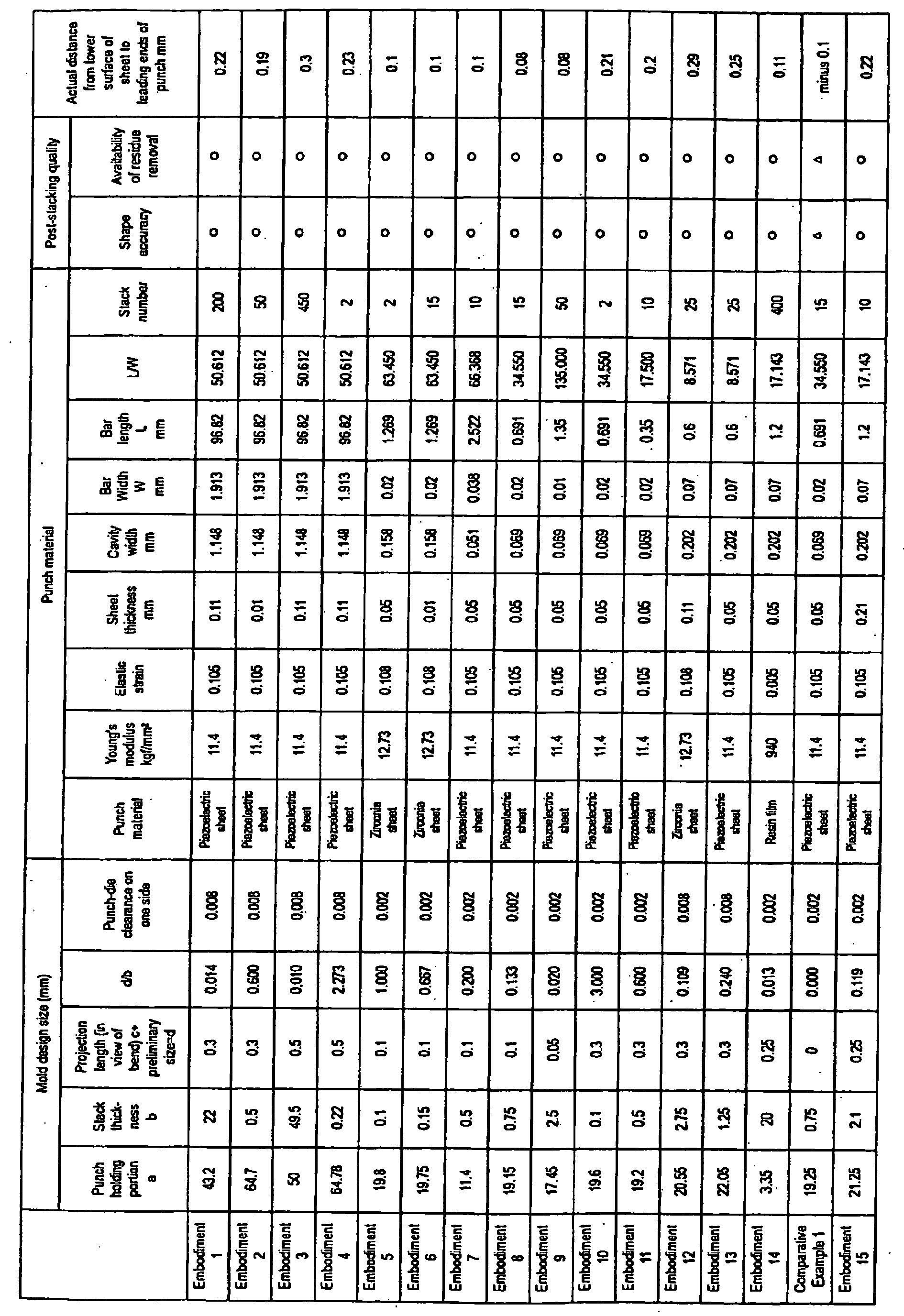

In the post-stacking qualities shown in Table 1, the marks ○ and Δ indicate the following. As for the shape accuracy, the mark ○ indicates that the shape accuracy is good, while the mark Δ indicates that skill is required to obtain good shape accuracy and that a check is required to prevent double punching. As for the availability of the residue removal operation, the mark ○ indicates that the residue removal operation is easily performed, while the mark Δ indicates that the residue removal operation is performed with difficulty and that the selection of a roller and careful handling of the roller are required to prevent deformation of the bar portions.

Consideration: As is obvious from the results shown in Table 1, the manufacturing method according to the present invention could form through holes, with high shape accuracy, in a punch material of a punched shape having a ratio (L/W) of greater than 17 between the through hole interval (i.e., bar width) W and the bar length L. Further, the manufacturing method according to the present invention could form, with high shape accuracy, minute through holes of an elongated oval shape with a narrow bar width and a long bar length, i.e., a through hole interval (i.e., a bar width) W of equal to or less than 0.07 mm and a bar length L of equal to or greater than 0.6 mm, in a punch material having a thickness of equal to or less than 0.11 mm.

As described above, even when forming through holes in a punch material with a narrow bar width and a long bar length, the present invention can provide an industrial component formed with the through holes with high shape accuracy. Therefore, a desired wiring board or liquid discharge nozzle, for example, can be manufactured. The present invention thus contributes to the improvement of the mounting technique of an industrial product, and can provide a more downsized and convenient product.

## Claims

1. A method of manufacturing an industrial component having through holes (2) with a high aspect ratio by using a punch (10) and a die (12), the punch (10) having leading ends formed into punching cutters, the method including the steps:
punching plural sheets of punch materials (3) using the punching cutters and thereafter keeping held the plural sheets of punch materials (3) by a side surface of the punch (10), the leading ends of the punch (10) serving as stacking axes for the plural sheets of punch materials (3), wherein whilst a given punch material (3) is held by the side surface of the punch (10), and, before punching a next punch material, the leading ends of the punch (10) project farther than the lowest surface of the given punch material (3), and then
punching and stacking said next punch material whilst the leading ends of the punch (10) are projecting farther than the lowest surface of the given punch material (3).

2. The method of manufacturing an industrial component according to Claim 1,
wherein a punched shape of the punch material (3) has a ratio L/W of greater than 17 between a bar width W and a bar length L, the bar width W corresponding to a through hole (2) interval.

3. The method of manufacturing an industrial component according to Claim 1 or 2,
wherein a punched shape of the punch material (3) has a bar width of equal to or less than 0.07 mm, a bar length of equal to or greater than 0.6 mm, and a thickness of equal to or less than 0.11 mm, the bar width corresponding to a through hole (2) interval.

## Patentansprüche

1. Verfahren zur Herstellung einer Industriekomponente mit Durchgangslöchern (2) mit einem großen Aspektverhältnis unter Verwendung eines Stanzstempels (10) und einer Stanzmatrize (12), wobei der Stanzstempel (10) vordere Enden aufweist, die zu Stanzschneiden geformt sind, wobei das Verfahren folgende Schritte umfasst:
das Stanzen mehrerer Bahnen Stanzmaterial (3) unter Einsatz der Stanzschneiden und anschließend das Halten der mehreren Bahnen Stanzmaterial (3) an einer Seitenfläche des Stanzstempels (10), wobei die vorderen Enden des Stanzstempels (10) als Stapelachsen für die mehreren Bahnen Stanzmaterial (3) dienen, worin die vorderen Enden des Stanzstempels (10), wenn ein Stanzmaterial (3) an der Seitenfläche des Stanzstempels (10) gehalten wird und vor dem Stanzen des nächsten Stanzmaterials, weiter vorstehen als die unterste Fläche des Stanzmaterials (3), und anschließend
das Stanzen und Stapeln des nächsten Stanzmaterials, während die vorderen Ende des Stanzstempels (10) weiter vorstehen als die unterste Fläche des Stanzmaterials (3).

2. Verfahren zur Herstellung einer Industriekomponente nach Anspruch 1,
worin eine gestanzte Form des Stanzmaterials (3) ein Längen/Breiten-Verhältnis einer Lamellenbreite W und einer Lamellenlänge L von mehr als 17 aufweist, wobei die Lamellenbreite W dem Abstand zwischen Durchgangslöchern (2) entspricht.

3. Verfahren zur Herstellung einer Industriekomponente nach Anspruch 1 oder 2 umfasst,
worin die gestanzte Form des Stanzmaterials (3) eine Lamellenbreite von 0,07 mm oder weniger, eine Lamellenlänge von 0,6 mm oder mehr und eine Dicke von 0,11 mm oder weniger aufweist, wobei die Lamellenbreite dem Abstand zwischen Durchgangslöchern (2) entspricht.

## Revendications

1. Procédé pour fabriquer un composant industriel ayant des trous de passage (2) avec un rapport de forme élevé en utilisant un poinçon (10) et une matrice (12), le poinçon (10) ayant des extrémités d'attaque formées dans des dispositifs de coupe de poinçonnage, le procédé comprenant les étapes consistant à :
poinçonner plusieurs feuilles de matériaux de poinçon (3) en utilisant les dispositifs de coupe de poinçonnage et continuer à maintenir ensuite les plusieurs feuilles de matériaux de poinçon (3) par une surface latérale du poinçon (10), les extrémités d'attaque du poinçon (10) servant d'axes d'empilage pour les plusieurs feuilles de matériaux de poinçon (3), dans lequel, alors qu'un matériau de poinçon (3) donné est maintenu par la surface latérale du poinçon (10), et avant de poinçonner un matériau de poinçon suivant, les extrémités d'attaque du poinçon (10) font saillie plus loin que la surface la plus basse du matériau de poinçon (3) donné, et ensuite
poinçonner et empiler ledit matériau de poinçon suivant alors que les extrémités d'attaque du poinçon (10) font saillie plus loin que la surface la plus basse du matériau de poinçon (3) donné.

2. Procédé pour fabriquer un composant industriel selon la revendication 1,
dans lequel une forme poinçonnée du matériau de poinçon (3) a un rapport L/W supérieur à 17 entre une largeur de barre W et une longueur de barre L, la largeur de barre W correspondant à un intervalle de trou de passage (2).

3. Procédé pour fabriquer un composant industriel selon la revendication 1 ou 2,
dans lequel une forme poinçonnée du matériau de poinçon (3) a une largeur de barre égale ou inférieure à 0,07 mm, une longueur de barre égale ou supérieure à 0,6 mm, et une épaisseur égale ou inférieure à 0,11 mm, la largeur de barre correspondant à un intervalle du trou de passage (2).
